Europäisches Patentamt

(19) European Patent Office

Office européen des brevets

(11) EP 1 542 281 A1

(12) EUROPEAN PATENT APPLICATION
published in accordance with Art. 158(3) EPC

(43) Date of publication:
15.06.2005 Bulletin 2005/24

(51) Int Cl.7: H01L 23/373, C08K 3/00,
C08L 33/08, C08L 53/00,
C08L 101/00

(21) Application number: 03784597.1

(22) Date of filing: 08.08.2003

(86) International application number:
PCT/JP2003/010112

(87) International publication number:
WO 2004/015768 (19.02.2004 Gazette 2004/08)

(84) Designated Contracting States:
AT BE BG CH CY CZ DE DK EE ES FI FR GB GR
HU IE IT LI LU MC NL PT RO SE SI SK TR

(30) Priority: 09.08.2002 JP 2002233597
20.03.2003 JP 2003078203

(71) Applicant: SEKISUI CHEMICAL CO., LTD.
Osaka-shi, Osaka 530-8565 (JP)

(72) Inventors:
• AZUMA, Kenichi, c/o Sekisui Chemical Co., Ltd.
Mishima-gun, Osaka 618-8589 (JP)
• HASEGAWA, Atsushi,
c/o Sekisui Chemical Co., Ltd.
Mishima-gun, Osaka 618-8589 (JP)
• HYODO, Shunji, c/o Sekisui Chemical Co., Ltd.
Hasuda-shi, Saitama 349-0198 (JP)

(74) Representative: Hart Davis, Jason et al
Cabinet Beau de Loménie,
158, rue de l'Université
75340 Paris Cedex 07 (FR)

(54) HEAT-DISSIPATING MEMBER AND JOINED STRUCTURE

(57) It is an object of the present invention to provide a heat-dissipating member, which has an excellent handling property at room temperature and can tightly adhere to a heat generating element and a heat sink by being interposed between the heat generating element and the heat sink and by having high flexibility to efficiently conduct heat generated from the heat generating element to the heat sink and can keep the state of adherence even in increasing in temperature, and a joined structure obtainable by joining a heat sink to a heat generating element with the heat-dissipating member.

The present invention relates to a heat-dissipating member, which comprises a thermoplastic resin composition containing a thermoplastic resin and a thermally conductive fine particle and not containing a compound having a melting temperature in the range of 40 to 80°C, at 23°C, a storage modulus at 0.1 Hz is 50,000 Pa or larger and the member remains finite in shape, and in the range of 50 to 80°C, a storage modulus at 0.1 Hz being 400 to 50,000 Pa and the member being indefinite in shape, and at 100°C, a storage modulus at 0.1 Hz being 5,000 Pa or smaller and the member being indefinite in shape.

Fig. 1

**Description**

FIELD OF THE INVENTION

The present invention relates to a heat-dissipating member, which has an excellent handling property at room temperature and can tightly adhere to a heat generating element and a heat sink by being interposed between the heat generating element and the heat sink and by having high flexibility to efficiently conduct heat generated from the heat generating element to the heat sink and can keep the state of adherence even in increasing in temperature, and a joined structure obtainable by joining a heat sink to a heat generating element with the heat-dissipating member.

BACKGROUND ART

Heat-dissipating members such as heat-dissipating sheets are employed for the purpose of dissipating heat generated from a heat generating element by interposing them between a heat generating element and a heat sink of electric or electronic devices and the like. But, since not only heat generating elements and heat sinks of electric or electronic devices but also many heat generating elements and heat sinks have surfaces which are not smooth, heat-dissipating members cannot tightly adhere to the heat generating elements and the heat sinks and contact areas between heat generating elements or heat sinks and heat-dissipating members are reduced, and therefore efficiency of heat transfer from a heat generating element to a heat sink decreases and the heat dissipation performance of heat-dissipating members cannot be adequately exerted.

Resistance between the heat generating element and the heat sink with respect to heat transfer is referred to as thermal resistance, and when the thermal resistance is smaller, the heat transfer from the heat generating element to the heat sink is more excellent and a higher effect of heat dissipation can be attained. Hence, high flexibility is required for the heat-dissipating member in order to reduce the thermal resistance. Thus conventionally, there have been used heat-dissipating grease containing thermally conductive fine particles, heat-dissipating sheet obtainable by dispersing thermally conductive fine particles in a resin, which is flexible and has rebounding capability such as silicon rubber and acrylate resin, and the like.

As the heat-dissipating grease, there is disclosed a grease, which is silicon-based and contains thermally conductive fine particles such as zinc oxide, alumina, aluminum nitride and the like, for example in Japanese Kokoku Publication Hei-6-39591. Since such a heat-dissipating grease is a material having fluidity and viscosity, when the grease is interposed between the heat generating element and the heat sink, it can obtain a large contact area with them and therefore develop excellent thermal resistance performance. However, there were problems that in applying grease to the heat generating element and the heat sink, their workability was low due to occurrences of soil on the periphery and there was a high probability that the thermal resistance performance might vary due to occurrences of variations in work.

As the heat-dissipating sheet, there is disclosed a thermally conductive tape, obtainable by dispersing thermally conductive fine particles randomly in an acrylate resin, for example in Japanese Kokai Publication Hei-6-88061. Since such a heat-dissipating sheet is a sheet of finite shape, it can be easily affixed to the heat generating element and the heat sink and can keep the space between the heat generating element and the heat sink constant in being interposed between the heat generating element and the heat sink, and therefore it can develop stable thermal resistance performance. However, since the heat-dissipating sheet did not have fluidity, it was impossible to attain as high flexibility as the heat-dissipating grease and it was difficult to develop high thermal resistance performance.

On the other hand, there is disclosed a heat-dissipating member, obtainable by mixing a compound such as an alpha-olefinic thermoplastic component having a melting temperature in the range of about 50 to 60°C or a paraffinic wax component having a melting temperature of about 60 to 70°C into an acrylic pressure sensitive viscous component, for example in Japanese Kohyo Publication No. 2000-509209. These heat-dissipating members soften rapidly when by applying voltage, a temperature of a heat generating element rises and reaches the melting temperature of the alpha-olefinic thermoplastic component or the paraffinic wax component mixed and improve in the flexibility and therefore in the thermal resistance performance.

However, since the compounds having such melting temperatures are solid matter not having viscosity at a temperature around 23°C at which the work of affixing the heat-dissipating member to the heat generating element and the heat sink is carried out, the viscosity of the acrylic pressure sensitive viscous component containing this compound is inhibited and the workability of affixing is deteriorated. Further, in the case where a temperature of the heat generating element rises and exceeds the melting temperature, the temperature of the heat generating element rises rapidly once because it takes some time before the entire compound melts. And, when the compound having a melting temperature is melted, the flexibility of the heat-dissipating member improves and the heat generating element and the heat sink tightly adhere to each other, a heat transfer coefficient improves, and then the temperature of the heat generating element drops rapidly. Therefore, there was a problem that a temperature load was put, but for short time, on the heat generating element. Further, there was also a problem that even if the compound was melted through an increase in temperature of the heat generating element and the flexibility of the heat-dissipating member improved, and the heat generating element and the heat sink tightly adhered to each other and a heat transfer coefficient improved, in the case where heat addition was continued, the melted compound having low viscosity runs away from the heat-dissipating member, and consequently the adhesion was impaired and the heat transfer coefficient was also deteriorated, and a temperature of the heat generating element might rise.

SUMMARY OF THE INVENTION

In view of the state of the art, it is an object of the present invention to provide a heat-dissipating member, which has an excellent handling property at room temperature and can tightly adhere to a heat generating element and a heat sink by being interposed between the heat generating element and the heat sink and by having high flexibility to efficiently conduct heat generated from the heat generating element to the heat sink and can keep the state of adherence even in increasing in temperature, and a joined structure obtainable by joining a heat sink to a heat generating element with the heat-dissipating member.

The present invention pertains to a heat-dissipating member which comprises a thermoplastic resin composition containing a thermoplastic resin and a thermally conductive fine particle and not containing a compound having a melting temperature in the range of 40 to 80°C, at 23°C, a storage modulus at 0.1 Hz being 50,000 Pa or larger and the member remains finite in shape, and in the range of 50 to 80°C, a storage modulus at 0.1 Hz being 400 to 50,000 Pa and the member being indefinite in shape, and at 100°C, a storage modulus at 0.1 Hz being 5,000 Pa or smaller and the member being indefinite in shape.

The thermoplastic resin is preferably a styrene block copolymer and/or a butyl-rubber resin. The styrene block copolymer is more preferably a styrene-isoprene-styrene block copolymer having the proportion of diblock of styrene-isoprene being 50% by weight or larger and the content of styrene being 25% by weight or smaller. And, preferably, the thermoplastic resin composition mainly contains an aromatic thermoplastic resin being solid at 23°C and further contains a xylene resin having viscosity at 23°C.

A joined structure obtainable by joining a heat sink to a heat generating element with the heat-dissipating member of the present invention, wherein thickness of the heat-dissipating member can be reduced by heat generation of the heat generating element compared with thickness of the member before the heat generation, also constitutes the present invention.

A joined structure obtainable by joining a heat sink to a heat generating element with the heat-dissipating member of the present invention, wherein thickness of the heat-dissipating member has already been reduced by heat generation of the heat generating element compared with thickness of the member before the heat generation, also constitutes the present invention.

BRIEF DESCRIPTION OF THE DRAWINGS

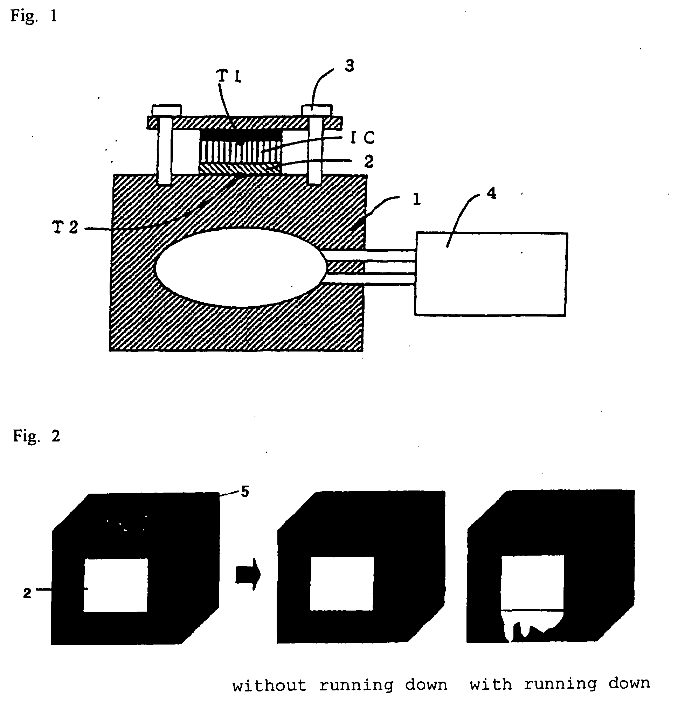

Fig. 1 is a schematic view showing a measuring apparatus used for measuring thermal resistance of a heat-dissipating member. Fig. 2 is a schematic view illustrating a method of evaluating high temperature fluidity in Examples.

In drawing, reference numerals 1, 2, 3, 4 and 5 denote a cooler, a heat-dissipating member, a bolt, a thermostatic water tank and an aluminum block, respectively.

DETAILED DESCRIPTION OF THE INVENTION

Hereinafter, the present invention will be described in detail.

The heat-dissipating member of the present invention has a storage modulus of 50,000 Pa or larger at 0.1 Hz and remains finite in shape at 23°C. Accordingly, this member can be used in the form of a sheet of finite shape at a temperature around 23°C at which the work of affixing the member to the heat generating element and the heat sink is carried out, and exhibits excellent workability of affixing. When the storage modulus at 0.1 Hz at 23°C is smaller than 50,000 Pa, the member is too soft and hard to handle, and the work of affixing is hard to carry out.

The heat-dissipating member of the present invention has a storage modulus of 400 to 50,000 Pa at 0.1 Hz and is indefinite in shape in the range of 50 to 80°C. Accordingly, when a temperature of a heat generating element rises by applying voltage, the heat-dissipating member softens rapidly, and when the member reaches a temperature of 50 to 80°C, it improves in the flexibility and hence its contact area with the heat generating element and the heat sink is enhanced, and therefore it develops an excellent thermal resistance performance. When the storage modulus at 0.1 Hz in the range of 50 to 80°C is smaller than 400 Pa, the heat-dissipating member runs away from the heat generating element and the heat sink due to being too soft, and when it is larger than 50,000 Pa, the heat-dissipating member cannot tightly adhere to the heat generating element and the heat sink due to its low flexibility and therefore sufficient thermal resistance performance cannot be attained.

The heat-dissipating member of the present invention has a storage modulus of 5,000 Pa or smaller at 0.1 Hz and is indefinite in shape at 100°C. When the storage modulus at 0.1 Hz at 100°C is more than 5,000 Pa, it is difficult to process the member in sheet form.

Incidentally, the storage modulus can be measured using a dynamic viscoelasticity measuring apparatus such as Dynamic Analyzer RDA II manufactured by Rheometric Scientific, Inc.

In the heat-dissipating member of the present invention, a phenomenon of phase transition does not occur in the range of 40 to 80°C since the member does not contain a compound having a melting temperature in this range. In the present invention, since such a rapid change in the storage modulus occurs without involving the phenomenon of phase transition between 40°C and 60°C, the heat-dissipating member increasingly adheres to the heat generating element and the heat sink in conformity with an increase in the temperature of heat generating element and there is not the time delay between the instant of an increase in the temperature of heat generating element and the instant that the heat-dissipating member softens and its contact area with the heat generating element and the heat sink is enhanced and therefore it develops an excellent thermal resistance performance. Therefore, the temperature of the heat generating element does not rise rapidly and a temperature load is not put on the heat generating element. And, in the case of a thermoplastic resin composition not involving a phenomenon of phase transition, generally, the resin composition can become soft by only heating slightly higher than room temperature or viscosity can occur on the surface of a resin and therefore it is often hard to handle as a heat-dissipating member, but the heat-dissipating member of the present invention has an excellent handling property since it can remain finite in shape at low temperature.

In a temperature of above 60°C, since a decrease in the storage modulus of the heat-dissipating member of the present invention becomes mild, the heat-dissipating member does not run away from the heat generating element and the heat sink due to being too soft and it can continue to tightly adhere to the heat generating element and the heat sink and to efficiently conduct heat generated from the heat generating element to the heat sink.

Preferably, the heat-dissipating member of the present invention has the adhesion of 0.5 N/cm$^2$ or larger to aluminum at 23°C. Thereby, it has high adhesion to the heat generating element and the heat sink and the workability of affixing in affixing the heat-dissipating member to the heat generating element and the heat sink is improved.

The heat-dissipating member of the present invention is not particularly limited but it is preferred to process the member in sheet form for use. By processing the member in sheet form, the workability of affixing it is significantly improved.

When the heat-dissipating member of the present invention is in sheet form, the thickness of the sheet is preferably 20 to 400 μm. When the thickness is smaller than 20 μm, a handling property is deteriorated and in addition to this it may become difficult to adequately fill a gap when the heat-dissipating member is interposed between the heat generating element and the heat sink, and when it is larger than 400 μm, the thermal resistance performance tends to decrease.

The heat-dissipating member of the present invention comprises a thermoplastic resin composition containing a thermoplastic resin and thermally conductive fine particles.

As the thermoplastic resin, there are given (meth)acrylate copolymers; styrene block copolymers such as styrene-butadiene-styrene block copolymer, styrene-isoprene-styrene block copolymer and the like; ethylenevinyl acetate resin, butadiene resins, isobutylene resins, olefine resins, urethane resins, epoxy resins, vinyl acetate resins, styrene resins, butyral resin, polyvinyl alcohol resins, silicon resins; and modified resins thereof. These resins may be used alone or in combination of two or more species. Among others, acrylate copolymers, styrene block copolymers, and butyl-rubber resins are suitable in that design which can realize the storage modulus is relatively easy.

However, the thermoplastic resin is preferably not a substance having a melting point in the vicinity of a higher operating limit temperature in heat generating elements such as electronic devices like IC. Also, in the case of resins having a temperature of glass transition, it is preferred that a temperature of glass transition measured with a differential calorimeter is not present in the vicinity of a higher maximum proper operating temperature in heat generating elements such as electronic devices like IC. The absorption of latent heat in melting and a phenomenon of glass transition of these resins may also cause a time delay before the heat generating element or heat sink and the heat-dissipating member tightly adhere to each other.

When an acrylate copolymer is used as the thermoplastic resin, an acrylate copolymer having a weight average molecular weight of 5,000 to 200,000 is preferably used. When the acrylate copolymer having a weight average molecular weight within this range is used, it is possible to easily develop the storage modulus.

When a styrene block copolymer is used as the thermoplastic resin, it is preferred to use a styrene-isoprene-styrene block copolymer in which the proportion of diblock of styrene-isoprene is 50% by weight or larger and the content of styrene is 25% by weight or smaller. In styrene-isoprene-styrene block copolymer, a change in elastic modulus in the range of 23°C to 50°C can be controlled by adjusting the proportion of diblock and the content of styrene and by selecting the range like this, it is possible to develop the storage modulus.

And, when an aromatic thermoplastic resin, being solid at 23°C, such as styrene block copolymer is used as the thermoplastic resin, preferably, the thermoplastic resin composition further contains a xylene resin having viscosity at 23°C. By adding such a xylene resin, a rapid change occurs in the behavior of the storage modulus between 23°C and 50°C and further a mild change in the storage modulus can be realized at 50°C or more. It is considered that the reason for this is that when an aromatic thermoplastic resin being solid at 23°C and a xylene resin having viscosity at 23°C are mixed and used, the mixture retains a solid state by an interaction between aromatic rings of respective resins at 23°C, but when a resin temperature is increased, the interaction is gradually weakened and rapidly weakened and it softens without involving a phenomenon of phase transition in a certain temperature region, and on the other hand even when the mixture reaches a given temperature, a interaction between aromatic rings like pseudo crosslinking remains and therefore a further fluidization is suppressed. And, since the xylene resin also acts as a tackifier, the workability in affixing the heat-dissipating member of the present invention to the heat generating element and the heat sink is improved by blending the xylene resin. However, since when an amount of the thermally conductive fine particles to be blended is increased, some kinds of particles has a tendency in which an elastic modulus at elevated temperature is reduced, it is necessary to appropriately adjust the species and the amount to be blended of thermoplastic resin and xylene resin to control the behavior of the elastic modulus of the heat-dissipating member of the present invention.

An amount of the xylene resin to be blended in the thermoplastic resin composition is preferably 10 to 90% by volume. When it is less than 10% by volume, the heat-dissipating member has low flexibility and cannot tightly adhere to the heat generating element and the heat sink and sufficient thermal resistance performance may not be attained, and when it is more than 90% by volume, it may become difficult to obtain a sheet of finite shape at 23°C.

As the thermally conductive fine particles, a substance comprising at least one species selected from the group consisting of, for example, boron nitride, aluminum nitride, alumina, aluminum, silicon carbide, zinc oxide, copper, metal hydroxide, graphite, magnesium oxide and silica is suitable.

As the metal hydroxide, there are given, for example, magnesium hydroxide, aluminum hydroxide and the like.

The thermally conductive fine particles are preferably surface treated in such a way that they can be homogeneously mixed with the thermoplastic resin in a high proportion.

An amount of the thermally conductive fine particles to be blended in the thermoplastic resin composition is preferably 10 to 90% by volume. When it is less than 10% by volume, a sufficient heat transfer coefficient may not be attained, and when it is more than 90% by volume, the adhesion to aluminum of the heat-dissipating member to be obtained is reduced and the workability of affixing it may be deteriorated.

The thermoplastic resin composition may contain fire-retarding material such as halogen compounds, phosphate compounds, metal hydroxides, titanium oxides, etc.; a coloring agent such as carbon black, white carbon, etc.; a powder-surface modifying agent such as silane coupling agent, titanate coupling agent, etc.; a dispersant of glycerol fatty acids; an antioxidant such as bisphenols and hindered phenols; a tackifier such as chroman resin, terpene phenol resin, phenol resin, rosin, terpene resin, aliphatic hydrocarbons and alicyclic hydrocarbon to such an extent that does not impair the desired elastic modulus and adhesion to aluminum as required.

A method of producing the heat-dissipating member of the present invention is not particularly limited and includes, for example, a method in which predetermined amounts of the thermoplastic resin and the thermally conductive fine particles are mixed using 2-roll mill, 3-roll mill, plasto mill, a kneader, a planetary mixer and Banbury mixer, and the resulting mixture was formed in the form of sheet having desired thickness by coating forming, extrusion and press molding.

The heat-dissipating member of the present invention is finite in shape at room temperature in the vicinity of 23°C and extremely superior in a handling property, and therefore it can produce a joined structure obtainable by joining the heat sink to the heat generating element with efficiency. When a temperature of a heat generating element of this joined structure is elevated, it rapidly softens without involving the phenomenon of phase transition involving the absorption of latent heat such as a phenomenon of glass transition and melting at the instant when the temperature is a given temperature or higher and its contact area with the heat generating element and the heat sink is enhanced and further thereby, thickness of the heat-dissipating member is reduced, and therefore it can develop an excellent thermal resistance performance. In addition, since such a change of the heat-dissipating member is rapid and occurs before the temperature of the heat generating element reaches a temperature which puts load on the heat generating element, the temperature load is not put on the heat generating element. Even when the temperature is further increased, the heat-dissipating member of the present invention continues to tightly adhere to the heat generating element and the heat sink without being further fluidized and the temperature load is not put on the heat generating element.

A joined structure obtainable by joining a heat sink to a heat generating element with the heat-dissipating member of the present invention, wherein thickness of the heat-dissipating member can be reduced by heat generation of the heat generating element compared with thickness of the member before the heat generation, also constitutes the present invention.

A joined structure obtainable by joining a heat sink to a heat generating element with the heat-dissipating member of the present invention, wherein thickness of the heat-dissipating member has already been reduced by heat generation of the heat generating element compared with thickness of the member before the heat generation, also constitutes the present invention.

BEST MODES FOR CARRYING OUT THE INVENTION

Hereinafter, the present invention will be described in further detail by way of examples, but the present invention is not limited to these examples.

(Example 1)

20 parts by weight of styrene-isoprene block copolymer in which the content of styrene was 22% by weight and the proportion of diblock was 66% by weight, 80 parts by weight of xylene resin (produced by MITSUBISHI GAS CHEMICAL COMPANY, INC., trade name "NIKANOL KL-05"), and 140 parts by weight of aluminum nitride (produced by TOKUYAMA CORP., trade name "GRADE F") were mixed with a plasto mill and a substance in slurry was obtained. A volume ratio of the aluminum nitride was 30% with respect to this substance in slurry.

Next, a release PET film was laid on a press plate and on this, a metal frame with thickness of 100 µm was placed and the resulting substance in slurry was poured within the metal frame. Then, on this, a release PET film was placed to form a sample and this sample was sandwiched from above and below with press plates and press molding was conducted at room temperature. Thereby, a heat-dissipating member of 100 µm in thickness in sheet form, to which the release PET films were attached on both sides, was obtained.

(Example 2)

20 parts by weight of styrene-isoprene block copolymer in which the content of styrene was 22% by weight and the proportion of diblock was 66% by weight, 80 parts by weight of xylene resin (produced by MITSUBISHI GAS CHEMICAL COMPANY, INC., trade name "NIKANOL KL-05"), and 330 parts by weight of aluminum nitride (produced by TOKUYAMA CORP., trade name "GRADE F") were mixed with a plasto mill and a substance in slurry was obtained. A volume ratio of the aluminum nitride was 50% with respect to this substance in slurry.

By using this substance in slurry and following the same procedure as in Example 1, a heat-dissipating member of 100 µm in thickness in sheet form, to which the release PET films were attached on both sides, was obtained.

(Example 3)

20 parts by weight of styrene-isoprene-styrene block copolymer in which the content of styrene was 22% by weight and the proportion of diblock was 66% by weight, 40 parts by weight of xylene resin (produced by MITSUBISHI GAS CHEMICAL COMPANY, INC., trade name "NIKANOL KL-05"), 25 parts by weight of xylene resin (produced by MITSUBISHI GAS CHEMICAL COMPANY, INC., trade name "NIKANOL LL"), 15 parts by weight of liquid polyisoprene (produced by KURARAY Co., Ltd., trade name "LIR30"), and 400 parts by weight of alumina (produced by SHOWA DENKO K.K., trade name "CB-A20S") and 200 parts by weight of alumina (produced by SHOWA DENKO K.K., trade name "CB-A05S") were mixed with a plasto mill and a substance in slurry was obtained. A volume ratio of aluminum nitride was 60% with respect to this substance in slurry.

By using this substance in slurry and following the same procedure as in Example 1, a heat-dissipating member of 100 µm in thickness in sheet form, to which the release PET films were attached on both sides, was obtained.

(Example 4)

10 parts by weight of styrene-isoprene-styrene block copolymer in which the content of styrene was 55% by weight and the proportion of diblock was 16% by weight, 10 parts by weight of styrene-isoprene-styrene block copolymer in which the content of styrene was 22% by weight and the proportion of diblock was 66% by weight, 65 parts by weight of xylene resin (produced by MITSUBISHI GAS CHEMICAL COMPANY, INC., trade name "NIKANOL KL-05"), 15 parts by weight of liquid polyisoprene (produced by KURARAY Co., Ltd., trade name "LIR403"), and 400 parts by weight of alumina (produced by SHOWA DENKO K.K., trade name "CB-A20S") and 200 parts by weight of alumina (produced by SHOWA DENKO K.K., trade name "CB-A05S") were mixed with a plasto mill and a substance in slurry was obtained. A volume ratio of aluminum nitride was 60% with respect to this substance in slurry.

By using this substance in slurry and following the same procedure as in Example 1, a heat-dissipating mem-

ber of 100 μm in thickness in sheet form, to which the release PET films were attached on both sides, was obtained.

(Comparative Example 1)

30 parts by weight of styrene-isoprene block copolymer in which the content of styrene was 22% by weight and the proportion of diblock was 66% by weight, 70 parts by weight of dodecylbenzene, and 760 parts by weight of aluminum nitride (produced by TOKUYAMA CORP., trade name "GRADE F") were mixed with a plasto mill and a substance in slurry was obtained. A volume ratio of the aluminum nitride was 70% with respect to this substance in slurry.
By using this substance in slurry and following the same procedure as in Example 1, a heat-dissipating member of 100 μm in thickness in sheet form, to which the release PET films were attached on both sides, was obtained.

(Comparative Example 2)

50 parts by weight of styrene-isoprene block copolymer in which the content of styrene was 22% by weight and the proportion of diblock was 66% by weight, 50 parts by weight of dodecylbenzene, and 226 parts by weight of boron nitride (produced by DENKI KAGAKU KOGYO K.K., trade name "GRADE SGP") were mixed with a plasto mill and a substance in slurry was obtained. A volume ratio of the boron nitride was 50% with respect to this substance in slurry.
By using this substance in slurry and following the same procedure as in Example 1, a heat-dissipating member of 100 μm in thickness in sheet form, to which the release PET films were attached on both sides, was obtained.

(Comparative Example 3)

A heat-dissipating member of 100 μm in thickness in sheet form, to which the release PET films were attached on both sides, was obtained by following the same procedure as in Example 1 except for employing 100 parts by weight of acrylate copolymer (produced by Negami Chemical Industrial Co., Ltd., trade name "S-2022 Rev.2": weight average molecular weight 270,000) in place of 20 parts by weight of styrene-isoprene block copolymer in which the content of styrene was 22% by weight and the proportion of diblock was 66% by weight, and 226 parts by weight of boron nitride (produced by DENKI KAGAKU KOGYO K.K., trade name "GRADE SGP") in place of 140 parts by weight of aluminum nitride (produced by TOKUYAMA CORP., trade name "GRADE F").

(Comparative Example 4)

20 parts by weight of styrene-isoprene block copolymer in which the content of styrene was 22% by weight and the proportion of diblock was 66% by weight, 80 parts by weight of dodecylbenzene, and 400 parts by weight of alumina (produced by SHOWA DENKO K.K., trade name "CB-A20S") and 200 parts by weight of alumina (produced by SHOWA DENKO K.K., trade name "CB-A05S") were mixed with a plasto mill and a substance in slurry was obtained. A volume ratio of the aluminum nitride was 60% with respect to this substance in slurry.
By using this substance in slurry and following the same procedure as in Example 1, a heat-dissipating member of 100 μm in thickness in sheet form, to which the release PET films were attached on both sides, was obtained.

(Comparative Example 5)

22 parts by weight of styrene-isoprene block copolymer in which the content of styrene was 22% by weight and the proportion of diblock was 66% by weight, 8 parts by weight of styrene-isoprene block copolymer in which the content of styrene was 30% by weight and the proportion of diblock was 30% by weight, 45 parts by weight of xylene resin (produced by MITSUBISHI GAS CHEMICAL COMPANY, INC., trade name "NIKANOL KL-05"), 25 parts by weight of liquid polyisoprene block copolymer (produced by KURARAY Co., Ltd., trade name "KL230"), and 400 parts by weight of alumina (produced by SHOWA DENKO K.K., trade name "CB-A20S") and 200 parts by weight of alumina (produced by SHOWA DENKO K.K., trade name "CB-A05S") were mixed with a plasto mill and a substance in slurry was obtained. A volume ratio of aluminum nitride was 60% with respect to this substance in slurry. By using this substance in slurry and following the same procedure as in Example 1, a heat-dissipating member of 100 μm in thickness in sheet form, to which the release PET films were attached on both sides, was obtained.

(Comparative Example 6)

A commercially available silicon grease (produced by Dow Corning Corporation, trade name "#340") was used. In evaluating thermal resistance, a PET film with thickness of 50 μm, a central portion of which was cut away in a size of 35 mm×35 mm, was placed on a heat sink and the silicon grease was poured within the hollow central portion and a layer of silicon grease, having a thickness of 50 μm, was formed by scraping excessive silicon grease off with a spatula.

<Evaluation>

On each of the heat-dissipating members obtained in Examples 1 to 4 and Comparative Examples 1 to 6, thermal resistance, a storage modulus and high-temperature fluidity were evaluated according to the following methods.

(Measurement of thermal resistance)

The thermal resistance was measured with a measuring apparatus shown in Fig. 1. That is, the heat-dissipating member 2, from which both release PET films were peeled off, was affixed on a cooler 1 made of aluminum, and further an IC to be a heat source was stacked thereon and it was secured with bolts 3 with a tightening torque of 1 N·m being applied.
The power to an IC was turned on and 80 W/h of power was supplied to it, and an IC's temperature T1 and a temperature T2 in the vicinity of the heat-dissipating member on the cooler 1 were measured after 60 minutes. Here, the cooler 1 is constructed in such a way that water from a thermostatic water tank 4 was supplied to the inside of the cooler in a temperature of 23°C and went in cycles. The thermal resistance was determined from the results of measurement using the following equation.

$$\text{Thermal resistance } (°C/W) = (T1-T2)/\text{amount of power}$$

$$\text{supplied to an IC} = (T1-T2)/80$$

(Measurement of storage modulus)

Using Dynamic Analyzer RDA II (manufactured by Rheometric Scientific, Inc.), the storage moduli of each heat-dissipating member at 23°C, 50°C, 80°C and 100°C were measured in a condition of 0.1 Hz.

(Evaluation of high-temperature fluidity)

As shown in Fig. 2, each heat-dissipating member, from which one side of the release PET films was peeled off, was affixed to a side of a block of a regular hexahedron comprising aluminum. This aluminum block was kept in a thermostatic chamber of 80°C and after a lapse of a week, the presence or absence of running down of the heat-dissipating member was visually observed.

Table 1

| | Thermal resistance (°C/W) | Storage modulus (Pa) | | | | High-temperature fluidity (running down) |
|---|---|---|---|---|---|---|
| | | 23°C | 50°C | 80°C | 100°C | |
| Example 1 | 0.118 | 207000 | 2380 | 906 | 710 | none |
| Example 2 | 0.098 | 487000 | 4560 | 1050 | 910 | none |
| Example 3 | 0.104 | 87000 | 2570 | 684 | 655 | none |
| Example 4 | 0.120 | 97000 | 2810 | 1440 | 362 | none |
| Comparative Example 1 | 0.115 | 26200 | 5600 | 110 | 85 | present |
| Comparative Example 2 | 0.135 | 37500 | 12500 | 200 | 156 | present |
| Comparative Example 3 | 0.365 | 123400 | 56800 | 5900 | 3280 | none |

Table 1   (continued)

| | Thermal resistance (°C/W) | Storage modulus (Pa) | | | | High-temperature fluidity (running down) |
| --- | --- | --- | --- | --- | --- | --- |
| | | 23°C | 50°C | 80°C | 100°C | |
| Comparative Example 4 | 0.092 | 14200 | 321 | 6 | 1 | present |
| Comparative Example 5 | 0.321 | 1560000 | 266000 | 30500 | 19000 | none |
| Comparative Example 6 | 0.090 | 8500 | 3700 | 4020 | 3990 | none |

INDUSTRIAL APPLICABILITY

In accordance with the present invention, it is possible to provide the heat-dissipating member, which has an excellent handling property at room temperature and can tightly adhere to a heat generating element and a heat sink by being interposed between the heat generating element and the heat sink and by having high flexibility to efficiently conduct heat generated from the heat generating element to the heat sink and can keep the state of adherence even in increasing in temperature, and the joined structure obtainable by joining a heat sink to a heat generating element with the heat-dissipating member.

**Claims**

1.  A heat-dissipating member,
    which comprises a thermoplastic resin composition containing a thermoplastic resin and a thermally conductive fine particle and not containing a compound having a melting temperature in the range of 40 to 80°C,
    at 23°C, a storage modulus at 0.1 Hz being 50,000 Pa or larger and the member remains finite in shape, and
    in the range of 50 to 80°C, a storage modulus at 0.1 Hz being 400 to 50,000 Pa and the member being indefinite in shape, and
    at 100°C, a storage modulus at 0.1 Hz being 5,000 Pa or smaller and the member being indefinite in shape.

2.  The heat-dissipating member according to claim 1,
    wherein the thermoplastic resin is a styrene block copolymer and/or a butyl-rubber resin.

3.  The heat-dissipating member according to claim 2,
    wherein the styrene block copolymer is a styrene-isoprene-styrene block copolymer having the proportion of diblock of styrene-isoprene being 50% by weight or larger and the content of styrene being 25% by weight or smaller.

4.  The heat-dissipating member according to claim 1, 2 or 3,
    wherein the thermoplastic resin composition mainly contains an aromatic thermoplastic resin being solid at 23°C and further contains a xylene resin having viscosity at 23°C.

5.  A joined structure obtainable by joining a heat sink to a heat generating element with the heat-dissipating member according to claim 1, 2, 3 or 4,
    wherein thickness of the heat-dissipating member may be reduced by heat generation of the heat generating element compared with thickness of the member before the heat generation.

6.  A joined structure obtainable by joining a heat sink to a heat generating element with the heat-dissipating member according to claim 1, 2, 3 or 4,
    wherein thickness of the heat-dissipating member has already been reduced by heat generation of the heat generating element compared with thickness of the member before the heat generation.

Fig. 1

Fig. 2

without running down    with running down

## INTERNATIONAL SEARCH REPORT

| | International application No. |
| --- | --- |
| | PCT/JP03/10112 |

**A. CLASSIFICATION OF SUBJECT MATTER**
Int.Cl$^7$ H01L23/373, C08K3/00, C08L33/08, 53/00, 101/00

According to International Patent Classification (IPC) or to both national classification and IPC

**B. FIELDS SEARCHED**

Minimum documentation searched (classification system followed by classification symbols)
Int.Cl$^7$ H01L23/373, C08K3/00, C08L33/08, 53/00, 101/00

Documentation searched other than minimum documentation to the extent that such documents are included in the fields searched
| | | | |
| --- | --- | --- | --- |
| Jitsuyo Shinan Koho | 1922-1996 | Toroku Jitsuyo Shinan Koho | 1994-2003 |
| Kokai Jitsuyo Shinan Koho | 1971-2003 | Jitsuyo Shinan Toroku Koho | 1996-2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 6-275748 A (Sharp Corp.), 30 September, 1994 (30.09.94), (Family: none) | 1-6 |
| A | JP 2001-274302 A (JSR Corp.), 05 October, 2001 (05.10.01), (Family: none) | 1-6 |
| A | JP 2002-270741 A (Nitto Shinko Kabushiki Kaisha), 20 September, 2002 (20.09.02), (Family: none) | 1-6 |

☐ Further documents are listed in the continuation of Box C.  ☐ See patent family annex.

| | |
| --- | --- |
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 18 November, 2003 (18.11.03) | 02 December, 2003 (02.12.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)